# EUROPEAN PATENT SPECIFICATION

(11) **EP 0 635 933 B1**
(45) Date of publication and mention of the grant of the patent: **30.09.1998**
(21) Application number: 94117668.7
(22) Date of filing: 06.02.1991
(51) Int. Cl.: H03F 3/60

(54) **Constant-amplitude wave combination type amplifier**
Verstärker für zusammengesetzte Wellen mit konstanter Amplitude
Amplificateur pour ondes d'amplitude constante combinée

(30) Priority: 07.02.1990 JP 27698/90; 07.02.1990 JP 27699/90; 07.02.1990 JP 27700/90
(43) Date of publication of application: 25.01.1995
(62) Divisional of application: 91101602.0
(73) Proprietor: FUJITSU LIMITED, Kawasaki-shi, Kanagawa 211 (JP)
(72) Inventor: Okubo, Naofumi, Kawasaki-shi, Kanagawa 212 (JP); Asano, Yoshihiko, Tokyo 146 (JP); Kurihara, Hiroshi, Tokyo 166 (JP); Daido, Yoshimasa, Yokohama-shi, Kanagawa 241 (JP); Kobayashi, Kazuhiko, Kawasaki-shi, Kanagawa 214 (JP); Kobayakawa, Shuji, Yokohama-shi, Kanagawa 240 (JP); Maniwa, Toru, Kawasaki-shi, Kanagawa 211 (JP)
(74) Representative: Lehn, Werner, Dipl.-Ing.

(56) References cited:
- GB-A- 2 073 516
- GB-A- 2 207 582
- US-A- 4 554 514

## Description

### BACKGROUND OF THE INVENTION

The present invention generally relates to a constant-amplitude wave combination type amplifier, and more particularly to a constant-amplitude wave combination type amplifier based on a LINC (linear amplification with non-linear components) process.

US-A-3 909 742 discloses an amplifier for linearly amplifying a bandpass high frequency analog input signal by a plurality of amplifying means including those having a non-linear characteristic. These amplifying means include first combining means for producing from the input signal first and second signal components having constant amplitude but differing in phase, first and second non-linear amplifiers for separately amplifying said first and second component signals, second combining means for recombining the amplified first and second component signals output by said first and second amplifiers, respectively, so as to generate an output signal formed by the difference of said first and second amplified component signals and being a linearly amplified replica of the input signal, and to also generate a feedback signal being the sum of said first and second amplified component signals and fed to said first combining means for combining the input and feedback signal.

Moreover, constant-amplitude wave combination type amplifiers have been widely used in various communication devices, such as radio devices for use in mobile communications, multiple radio devices, satellite communication radio devices, and broadcasting devices. There is a need to realize such constant-amplitude wave combination amplifiers which consume a small amount of power and which are configured of a small number of structural elements.

Constant-amplitude wave combination type amplifiers based on the LINC process are known as amplifiers which meet the above-mentioned need, and are disclosed in, for example, D.C. Cox, "Linear Amplification with Non-linear Components", IEEE Transactions on Communications, December 1974, pp. 1942-1945. An application of constant-amplitude wave combination type amplifiers based on the LINC process is proposed in Japanese Laid-Open Patent Application No. 1-284106.

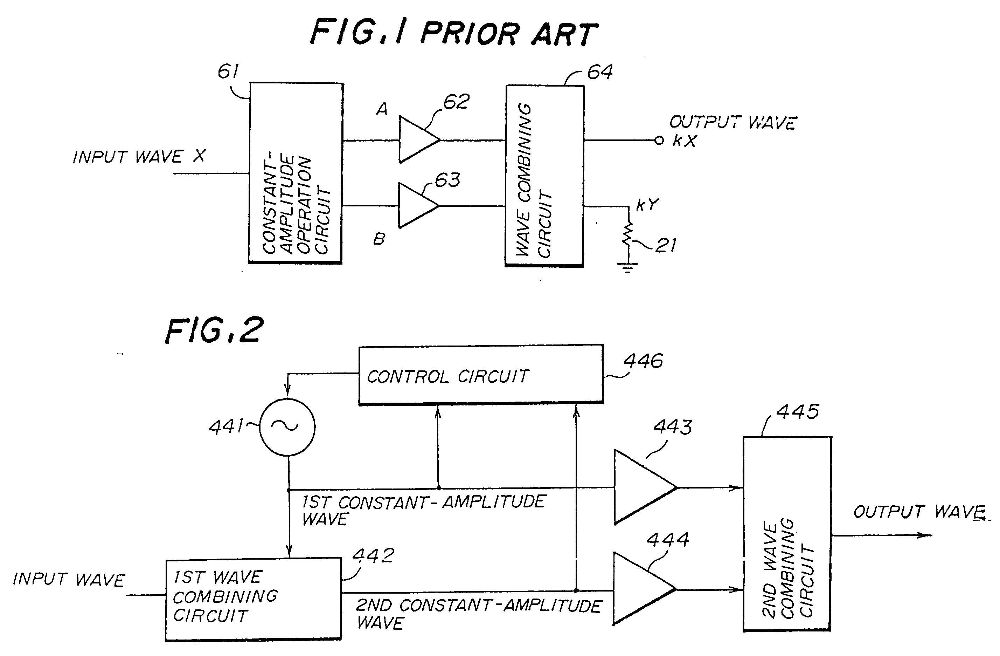

FIG.1 shows a conventional constant-amplitude wave combination type amplifier. As shown, the amplifier has a constant-amplitude wave operation circuit 61, two amplifiers 62 and 63, and a wave combining circuit 64. The constant-amplitude wave operation circuit 61 is formed of a digital signal processing circuit, and calculates an orthogonal wave Y orthogonal to an input wave X so that each combined wave obtained by combining the waves X and Y with each other has a constant amplitude. Then, the constant-amplitude wave operation circuit 61 outputs constant-amplitude waves A and B which have constant envelopes having equal amplitudes by the above-mentioned combination of the waves X and Y. Capital letters X, Y, A and B are vector amounts which include phases.

The amplifiers 62 and 63, which are formed of non-linear amplifiers such as C-class amplifiers, amplify the constant-amplitude waves A and 3, respectively. The wave combining circuit 64 combines constant amplitude waves kA and kB respectively output by the amplifiers 62 and 63, and generates an output wave kX which is an amplified version of the input wave X.

The conventional configuration shown in FIG.1 has an advantage in that the amplifiers 62 and 63 are not required to be formed of linear amplifiers, since it is sufficient to amplify the constant-amplitude waves A and B of the constant envelopes. In addition, since the original signal can be reproduced by the wave combining circuit 64, it is possible to linearly amplify the input wave X having little distortion irrespective of the use of the non-linear amplifiers.

As has been described previously, the constant-amplitude wave operation circuit 61 is formed of a digital signal processing circuit. However, the digital signal processing circuit consumes a large amount of power and is not suitable for high-speed signal processing. Further, the use of the digital signal processing circuit causes an increase in the size of the amplifier. For the above reasons, the use of conventional constant-amplitude wave combination type amplifiers is limited to special applications in which the amount of power consumed in the digital signal processing circuit or the size of the amplifier are negligible, or applications in which data is transferred at a low speed.

### SUMMARY OF THE INVENTION

It is a general object of the present invention to provide an improved constant-amplitude wave combination type amplifier in which the above-mentioned disadvantages are eliminated.

A more specific object of the present invention is to provide a constant-amplitude wave combination type amplifier which consumes a small amount of power, is formed of a small number of structural elements and operates at a high speed.

According to the present invention, the above-mentioned objects are achieved by a constant-amplitude wave combination type amplifier as specified in claim 1.

Further improvements according to the present invention are specified in claims 2 to 9 being dependent on claim 1.

### BRIEF DESCRIPTION OF THE DRAWINGS

The objects, features and advantages of the present invention will become more apparent from the following detailed description when read in conjuncton with the accompanied drawings showing in
Fig. 1 a block diagram of a conventional constant-amplitude wave combination type amplifier;
FIG.2 a block diagram illustrating an outline of a constant-amplitude wave combination type amplifier disclosed for explanation of the present invention;
FIG. 3 a block diagram illustrating the configuration shown in FIG.2 in more detail;
FIGS.4, 5 and 6 respectively graphs illustrating the operation of the configuration shown in FIG. 3;
FIG.7 a block diagram illustrating a variation of the configuration shown in FIG.3;
FIG 8 a block diagram illustrating an outline of a constant-amplitude wave combination type amplifier according to a preferred embodiment of the present invention;
FIG.9 a block diagram illustrating the configuration shown in FIG.8 in more detail;
FIG.10 is a block diagram illustrating a variation of the configuration shown in FIG.9;
FIG.11 is a block diagram illustrating an outline of a constant-amplitude wave combination type amplifier according to a further preferred embodiment of the present invention;
FIG.12 is a block diagram illustrating the configuration shown in FIG.11 in more detail;
FIG.13 is a block diagram illustrating a first variation of the configuration shown in FIG.12;
FIG.14 is a block diagram illustrating an outline of a second variation of the configuration shown in FIG.12; and
FIG.15 is a block diagram illustrating the configuration of the second variation shown in FIG.14 in more detail.

### DESCRIPTION OF THE PREFERRED EMBODIMENTS

With reference to Figs. 2 to 6, a description will now be given of a constant-amplitude wave combination type amplifier which will be referred to for explaining embodiments of the present invention. The amplifier shown in FIG.2 has first and second wave combining circuits 442 and 445, two amplifiers 443 and 444, a variable frequency generator 41 and a control circuit 446. The variable frequency generator 441 generates a first constant-amplitude wave, and the first wave combining circuit 442 generates a second constant-amplitude wave. The amplifiers 443 and 444 amplify the first and second constant-amplitude waves, respectively, and output amplified waves to the second wave combining circuit 445. The control circuit 446 calculates the difference between the first and second constant-amplitude waves, and controls the variable frequency generator 441 on the basis of the calculation result so that the above-mentioned difference becomes zero. With the above arrangement, it is possible to generate the constant-amplitude waves which have constant envelope amplitudes. Thus, the amplifiers 443 and 444 can be formed of analog non-linear amplifiers, and the output wave has little distortion.

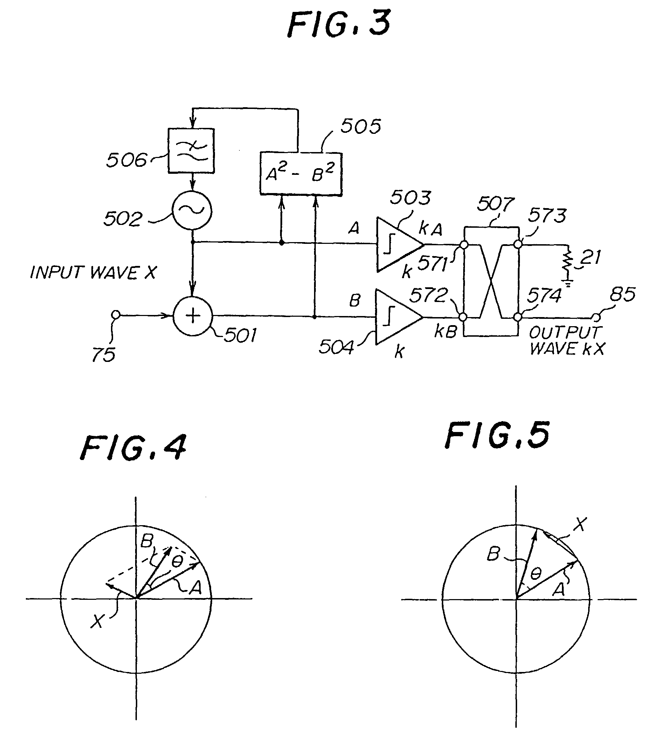

FIG.3 shows the configuration shown in FIG.2 in more detail. The input wave X is applied to an adder 501 via the input terminal 75. The adder 501 adds an input wave X and a constant-amplitude wave A generated by a voltage-controlled oscillator 502, which generates a constant-amplitude wave 3 therefrom. The constant-amplitude waves A and B are supplied to an operation circuit 505, which carries out an operation A² - B². The operation result indicates a value corresponding to the difference between the amplitudes of the constant-amplitude waves A and B, and is supplied to the voltage-controlled oscillator 502 via a lowpass filter 506. The lowpass filter 506 extracts a D.C. component from the output of the operation circuit 505. The D.C. component is supplied to the voltage-controlled oscillator 502 as a control signal (voltage) which corrects a phase error.

The constant-amplitude waves A and B are amplified by amplifiers 503 and 504, respectively, each having an amplification gain k. The amplifiers 503 and 504 can be formed of linear amplifiers, such as C-class amplifiers. Amplified outputs kA and kB output by the amplifiers 503 and 504 are applied to input terminals 571 and 572, respectively, of a 180°-out-of-phase hybrid circuit 507. The hybrid circuit 507 branches each of the amplified waves kA and kB into two waves. Then, the hybrid circuit 507 outputs in-phase components to identical direction output terminals (output terminals 573 and 574 with respect to the input terminals 571 and 572, respectively), and outputs 180°-out-of-phase components to cross-direction output terminals (output terminals 574 and 573 with respect to the input terminals 571 and 572, respectively). An output wave kX, which is an amplified version of the input wave X, is obtained at the output terminal 574 of the hybrid circuit 507. The output terminal 574 is terminated via the terminating resistor 21.

The operation of the amplifier shown in FIG.3 will now be explained. The input wave X is added to the constant-amplitude wave A from the voltage-controlled oscillator 502 on the vector base, so that the constant-amplitude wave B is output by the adder 501. If no phase shift control is carried out, the waves A, B and X will have a relationship shown in FIG.4. The amplitude of the constant-amplitude wave A is different from that of the combined wave B. Further, the amplitude of the combined wave B varies in accordance with a change of the amplitude of the constant-amplitude wave A. Thus, the combined wave B does not have a constant amplitude.

The operation circuit 505 carries out the operation A² - B², and the oscillating frequency (or phase) of the voltage-controlled oscillator 502 is controlled so that A² - B² = 0. That is, a phase angle Δθ between the waves A and B is adjusted so that the amplitudes of the waves A and B are equal to each other. In the state where A² - B² = 0, the amplifier shown in FIG.36 can operate stably. That is, as shown in FIG.5, the vector loci of the waves A and B are on a circle, so that the combined wave B can have a constant amplitude. As a result, the amplifiers 503 and 504 can be formed of analog non-linear amplifiers, such as C-class amplifiers.

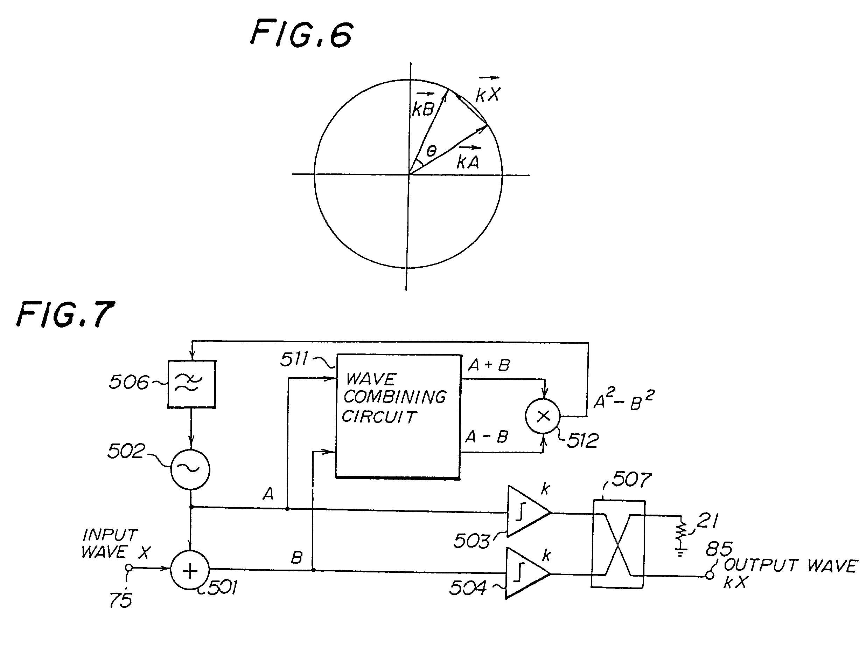

The amplified outputs kA and kB are input to the hybrid circuit 507, and combined therein. FIG.6 illustrates a phase relationship between the amplified outputs kA and kB. *An* output wave k(B - A) appears at the output terminal 574, which is an amplified version of the input wave X. That is, kX = k(B - A).

FIG.7 illustrates a variation shown in FIG.2. In FIG.40, those parts which are the same as those shown in FIG.36 are given the same reference numerals. The operation circuit 505 shown in FIG.36 is replaced by a wave combining circuit 511 and a multiplier 512. The wave combining circuit 511 combines the constant-amplitude waves A and B and generates two composite waves A + B and A - B. The multiplier 512 multiplies the wave A + B by the wave A - B, and outputs A² - B², which passes through the lowpass filter 506, and is applied to the voltage-controlled oscillator 502.

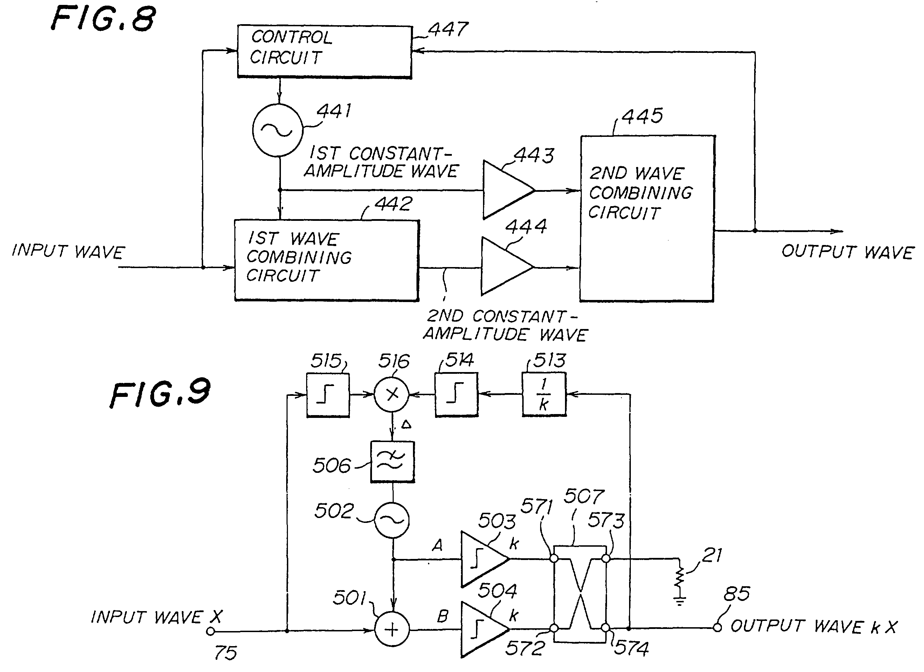

A description will now be given of a constant-amplitude wave combination circuit according to a preferred embodiment of the present invention with reference to FIG.8, in which those parts which are the same as those shown in FIG.2 are given the same reference numerals. A control circuit 447 is substituted for the control circuit 446 shown in FIG.35. The control circuit 447 extracts a distortion component contained in the output wave, and controls the gain of the variable frequency generator 441 so that the extracted distortion component is reduced. When the distortion component is sufficiently reduced, the first and second constant-amplitude waves generated respectively by the variable frequency generator 441 and the first wave combining circuit 442 have constant envelope amplitudes.

FIG.9 illustrates the configuration shown in FIG.8 in more detail. In FIG.9, those parts which are the same as those shown in FIG.3 are given the same reference numerals. The control circuit 447 shown in FIG.41 is made up of an attenuator 513 having an attenuation level 1/k, two limiter amplifiers 514 and 515, a multiplier 516 and a lowpass filter 506. The output wave kX generated by the 180°-out-of-phase hybrid circuit 507 passes through the attenuator 513 and the limiter amplifier 514, and is applied to the multiplier 516. On the other hand, the input wave X passes through the limiter amplifier 515 and is applied to the multiplier 516. The multiplier 516 multiplies the output from the limiter amplifier 514 by the output from the limiter amplifier 515, and generates a distortion component Δ contained in the output wave kX. The distortion component passes through the lowpass filter 506, and is applied, as the frequency (phase) control voltage, to the voltage-controlled oscillator 502.

If the combined wave B from the adder 501 is not a constant-amplitude wave, the amplified output kB will be distorted since the amplifier 504 is formed of a non-linear amplifier. Thus, the output wave kX will contain a distortion component. It can be seen from the above that if the combined wave B is a constant-amplitude wave, it is possible to minimize the distortion component contained in the output wave kX generated by the 180°-out-of-phase hybrid circuit 507.

The distortion component in the output wave kX is extracted by means of the attenuator 513, the limiter amplifiers 514 and 515 and the multiplier 516, and applied, as the frequency (or phase) control voltage, to the voltage-controlled oscillator 502. with the above control, the distortion component in the output wave kX is reduced, so that the combined wave B becomes a constant-amplitude wave.

It will be noted that the use of the limiter amplifier 515 is directed to maintaining the input signal at a certain level so that the circuit operation operates in the unstable state when the input wave X becomes small. The limiter amplifier 515 is provided for adjusting the phase relationship between the feedback loop carrying the output wave kX and the feedback loop carrying the input wave X.

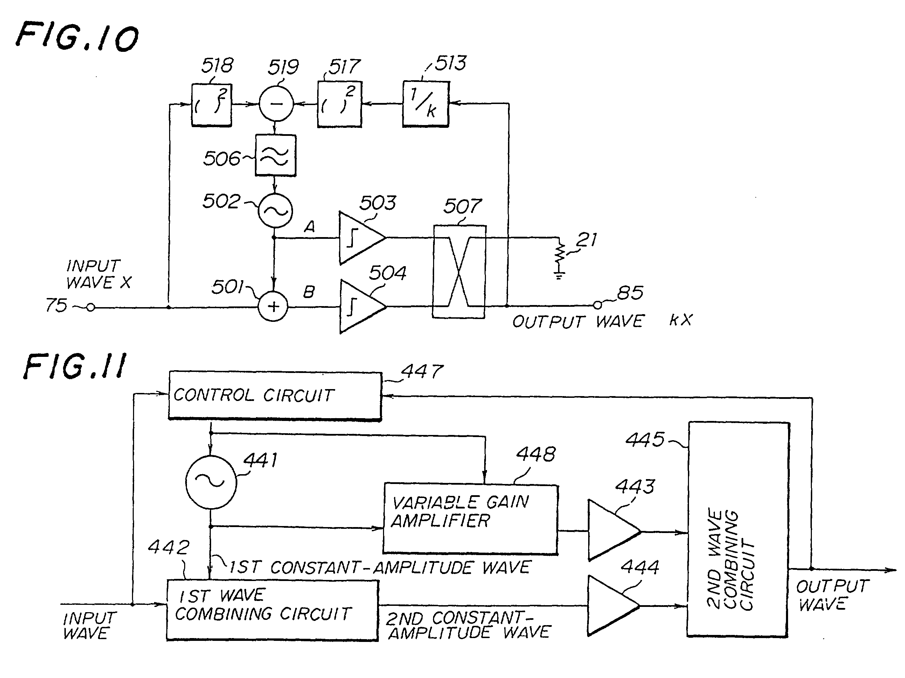

FIG.10 illustrates a variation of the configuration shown in FIG.9. In FIG.10, those parts which are the same as those shown in FIG.9 are given the same reference numerals. square-law circuits 517 and 518 are respectively substituted for the limiter amplifiers 514 and 515 shown in FIG.9, and a subtracter 519 is substituted for the multiplier 516 shown in FIG.9. The subtracter 519 outputs the distortion component contained in the output wave kX by calculating the difference between the output Wave kX passing through the attenuator 513 and the square-law circuit 517 and the input wave X from the square-law circuit 518.

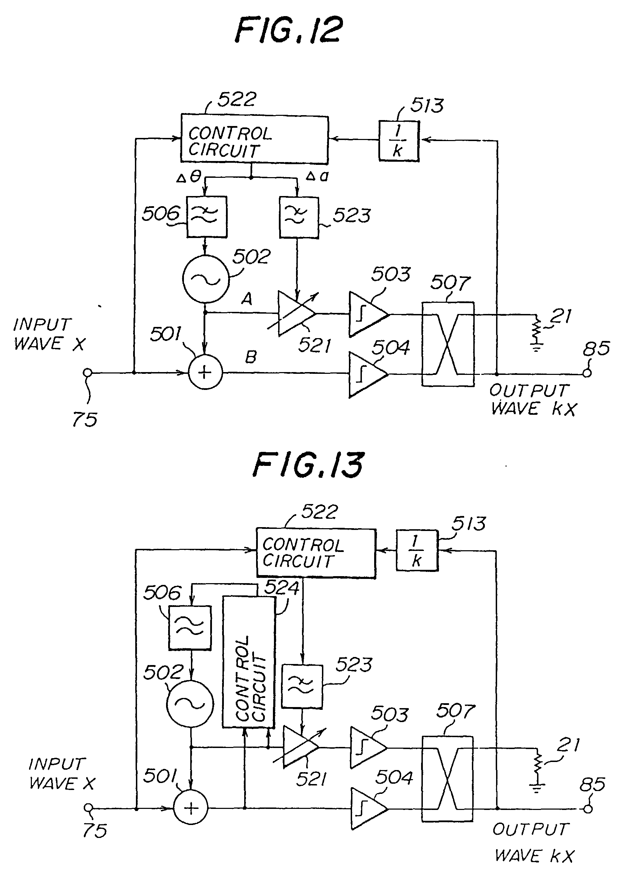

FIG.11 shows a constant-amplitude wave combination type amplifier according to a fourteenth embodiment of the present invention. In FIG.11, those parts which are the same as those shown in FIG.8 are given the same reference numerals. A variable gain amplifier 448 is provided between the output terminal of the variable frequency generator 441 and the amplifier 443. The variable gain amplifier 448 is controlled by the output signal of the control circuit 447 (distortion component) so that an amplitude error occurring between the constant-amplitude waves can be eliminated.

FIG.12 illustrates the configuration shown in FIG.11 in more detail. In FIG.12, those parts which are the same as those shown in FIG.9 are given the same reference numerals. The distortion component (Δθ) extracted from the output wave kX by a control circuit functions as the control voltage applied to the voltage-controlled oscillator 502 but also as a control voltage Δa applied to an AGC amplifier 521 through a lowpass filter 523. It will be noted that the control circuit 522 corresponds to the combination of the limiter amplifiers 514, 515 and the multiplier 516 shown in FIG.9, or the combination of the square-law circuits 517, 518 and the subtracter 519 shown in FIG.10.

In the configuration shown in FIG.9 or FIG.10, there is a possibility that the phase adjustment by the voltage-controlled oscillator 502 will not completely cancel an amplitude error occurring between the constant-amplitude waves A and B, although the phase error can be eliminated completely by the voltage-controlled oscillator 502. In this case, the output wave kX contains a distortion component. The configuration shown in FIG.12 is directed to eliminating such a distortion component. The distortion component extracted by the control circuit 522 is used for controlling not only the oscillation frequency of the voltage-controlled oscillator 502 but also the gain of the AGC amplifier 521 (amplitude of the constant-amplitude wave) so that the extracted distortion component is canceled. In this way, the configuration shown in FIG.12 adjusts the phase and amplitude. It will be noted that the AGC amplifier 521 can be provided between the adder 501 and the limiter amplifier 504.

FIG.13 illustrates a first variation based on the principle of the configuration shown in FIG.11. In FIG.13, those parts which are the same as those shown in FIG.10 are given the same reference numerals. The voltage-controlled oscillator 502 is controlled by a control circuit 524 provided separately from the control circuit 522. The control circuit 524 can be formed of, for example, the operation circuit 505 shown in FIG.3. The control voltage applied to the voltage-controlled oscillator 502 is generated from the amplitude difference obtained by calculating A² - B² by the control circuit 524. On the other hand, the control voltage applied to the AGC amplifier 521 is generated from the distortion component contained in the output wave kX by the control circuit 522.

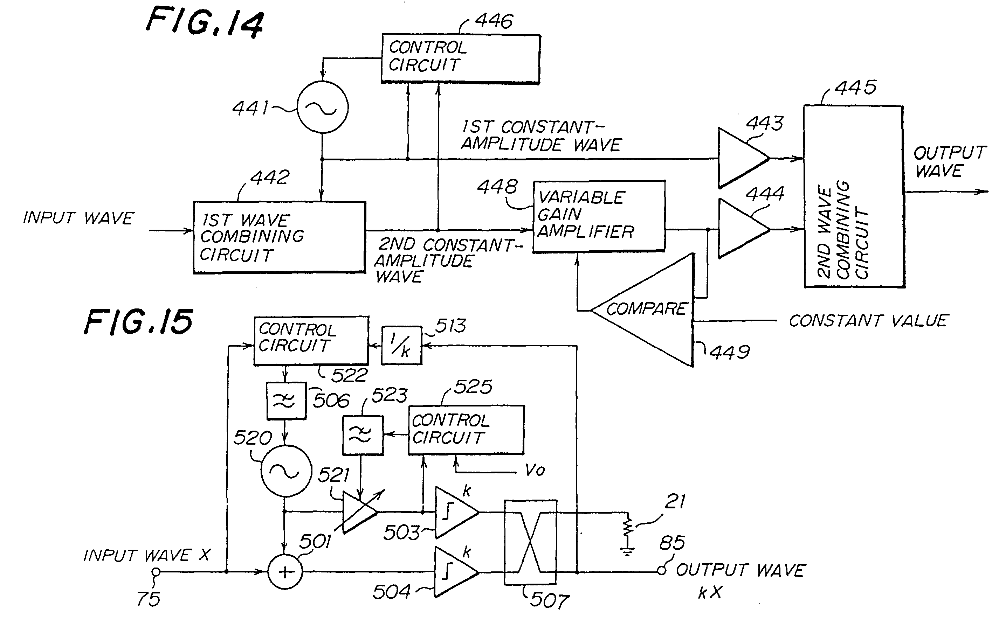

FIG.14 illustrates an outline of a second variation based on the principle of the configuration shown in FIG.11. In FIG.14, those parts which are the same as those shown in the previous figures are given the same reference numerals. The variable gain amplifier 448 is controlled by a comparator circuit 449, which compares the output signal of the variable gain amplifier 448 with a constant value.

FIG.15 illustrates the configuration shown in FIG.14 in more detail. In FIG.15, those parts which are the same as those shown in FIG. 12 are given the same reference numerals. A control circuit 525 corresponds to the comparator circuit 449 shown in FIG.14. That is, the control circuit 525 is made up of two square-law circuits 338 and 340, the 1/k attenuator 327 and the subtracter 339. When the AGC amplifier 521 operates normally, the output thereof has a constant amplitude. This constant amplitude is determined to be a reference value Vo. The control circuit 525 controls the gain of the AGC amplifier 521 via the lowpass filter 521 so that the output of the AGC amplifier 521 is equal to the reference value Vo. With the above arrangement, cancel an amplitude error can be cancelled.

## Claims

1. A constant-amplitude wave combination type amplifier, comprising
variable-frequency wave generating means (441, 502) for generating a first constant-amplitude wave (A) having a frequency controllable by a control signal;
first wave combining means (442, 501) coupled to said variable-frequency wave generating means, for generating a second constant-amplitude wave (B) by combining an input wave (X) and said first constant-amplitude wave (A);
a first amplifier (443, 503) amplifying said first constant-amplitude wave and outputting a first amplified output (kA);
a second amplifier (444, 504) amplifying said second constant-amplitude wave and outputting a second amplified output (kB);
second wave combining means (445, 507) coupled to said first and second amplifiers, for combining said first and second amplified outputs and for generating an output wave (kX); and
control means (447, 522) for generating said control signal from said input wave (X) and said output wave (kX) by generating a distortion component (Δ, Δθ) contained in said output wave (kX), and for adjusting the variable-frequency wave generating means (441, 502) so that said distortion component is reduced.

2. The constant-amplitude wave combination type amplifier as claimed in claim 1, wherein attenuating means (513) are provided for attenuating said output wave by a predetermined attenuation level (1/k) and which outputs an attenuated output wave to said control means.

3. The constant-amplitude wave combination type amplifier as claimed in claim 2, wherein said control means includes
a first limiter amplifier (514) which amplifies said attenuated output wave and which outputs an amplified attenuated output wave;
a second limiter amplifier (515) which amplifies said input wave and which outputs an amplified input wave; and
multiplying means (516) coupled to said first and second limiter amplifiers, for multiplying said amplified input wave by said amplified attenuated output wave and for generating a difference signal indicative of said distortion component contained in said output wave.

4. The constant-amplitude wave combination type amplifier as claimed in claim 2, wherein said control means further includes
a first square-law circuit (517) which squares said attenuated output wave and which outputs a first squared signal;
a second square-law circuit (518) which squares said input wave and which outputs a second squared signal;
a subtracter (519) coupled to said first and second square-law circuits, for outputting a difference signal indicative of a difference between said first and second squared signals and indicative of said distortion component contained in said output wave.

5. The constant-amplitude wave combination type amplifier as claimed in any of the preceding claims, wherein a first filter (506) is provided between said control means and said variable-frequency wave generating means, which filter extracts a first D.C. component from said distortion component for suppling it to said variable-frequency wave generating means.

6. The constant-amplitude wave combination type amplifier as claimed in claim 5, wherein said variable-frequency wave generating means (441, 502) comprises a voltage-controlled oscillator (502) controlled by said D.C. component.

7. The constant-amplitude wave combination type amplifier as claimed in any of the preceding claims, wherein variable gain amplifier means (448) are provided for amplifying one of said first and second constant-amplitude waves by a gain corresponding to said control signal generated by said control means.

8. The constant-amplitude wave combination type amplifier as claimed in claim 7, wherein a second filter (523) is provided for extracting a second D.C. component from said distortion component for suppling it to said variable gain amplifier means.

9. The constant-amplitude wave combination type amplifier as claimed in claim 8, wherein said variable gain amplifier means comprises an automatic gain control amplifier (521) controlled by said second D.C. component.

## Patentansprüche

1. Verstärker für zusammengesetzte Wellen mit konstanter Amplitude, enthaltend:
eine Wellenerzeugungsvorrichtung mit variabler Freuqenz (441, 502) zum Erzeugen einer ersten Welle konstanter Amplitude (A) mit einer durch ein Steuersignal steuerbaren Frequenz;
eine erste Wellenkombiniervorrichtung (442, 501), die an die Wellenerzeugungsvorrichtung mit variabler Frequenz gekoppelt ist, zum Erzeugen einer zweiten Welle konstanter Amplitude (B) durch Kombinieren einer Eingangswelle (X) und der ersten Welle konstanter Amplitude (A);
einen ersten Verstärker (443, 513) zum Verstärken der ersten Welle konstanter Amplitude und zum Ausgeben einer ersten verstärkten Ausgangsgröße (kA);
einen zweiten Verstärker (444, 504) zum Verstärken der zweiten Welle konstanter Amplitude zum Ausgeben einer zweiten verstärkten Ausgangsgröße (kB);
eine zweite Wellenkombiniervorrichtung (445, 507), die mit dem ersten und zweiten Verstärker gekoppelt ist, zum Kombinieren der ersten und zweiten verstärkten Ausgangsgröße und zum Erzeugen einer Ausgangswelle (kX); und
eine Steuervorrichtung (447, 522) zum Erzeugen des Steuersignals anhand der Eingangswelle (X) und der Ausgangswelle (kX) durch Erzeugen einer Verzerrungskomponente (Δ, Δθ), die in der Ausgangswelle (kX) enthalten ist, sowie zum Angleichen der Wellengeneriervorrichtung mit variabler Frequenz (441, 502) derart, daß die Verzerrungskomponente reduziert ist.

2. Verstärker für zusammengesetzte Wellen mit konstanter Amplitude nach Anspruch 1, dadurch gekennzeichnet, daß die Dämpfungsvorrichtung (513) zum Dämpfen der Ausgangswelle gemäß einem vorbestimmten Dämpfungspegel (1/k) vorgesehen ist und eine gedämpfte Ausgangswelle an die Steuervorrichtung ausgibt.

3. Verstärker für zusammengesetzte Wellen mit konstanter Amplitude nach Anspruch 2, dadurch gekennzeichnet, daß die Steuervorrichtung enthält:
einen ersten Begrenzerverstärker (514) zum Verstärken der gedämpften Ausgangswelle und zum Ausgeben einer verstärkten gedämpften Ausgangswelle;
einen zweiten Begrenzerverstärker (515) zum Verstärken der Eingangswelle und zum Ausgeben einer verstärkten Eingangswelle;
eine Multipliziervorrichtung (516), die an den ersten und zweiten Begrenzerverstärker gekoppelt ist, zum Multiplizieren der verstärkten Eingangswelle mit der gedämpften verstärkten Ausgangswelle zum Erzeugen eines Differenzsignals zum Anzeigen der Verzerrungskomponente in der Ausgangswelle.

4. Verstärker für zusammengesetzte Wellen konstanter Amplitude nach Anspruch 2, dadurch gekennzeichnet, daß die Steuervorrichtung ferner enthält:
eine erste einer quadratischen Funktion folgenden Schaltung (517) zum Quadrieren der gedämpften Ausgangswelle zum Ausgeben eines ersten quadrierten Signals;
eine zweite einer quadratischen Funktion folgenden Schaltung (518) zum Quadrieren der Eingangswelle und zum Ausgeben eines zweiten quadrierten Signals;
einen Subtrahierer (519), der mit der ersten und zweiten einer quadratischen Funktion folgenden Schaltung verbunden ist, zum Ausgeben eines Differenzsignals zum Anzeigen einer Differenz zwischen dem ersten und zweiten quadrierten Signal und zum Anzeigen der Verzerrungskomponente in der Ausgangswelle.

5. Verstärker für zusammengesetzte Wellen konstanter Amplitude nach einem der vorhergehenden Ansprüche, dadurch gekennzeichnet, daß ein erstes Filter (506) zwischen der Steuervorrichtung und der Wellengeneriervorrichtung mit variabler Frequenz vorgesehen ist, derart, daß das Filter eine erste DC-Komponente von der Verzerrungskomponente extrahiert, um es zu der Wellengeneriervorrichtung variabler Frequenz zuzuführen.

6. Verstärker für zusammengesetzte Wellen mit konstanter Amplitude nach Anspruch 5, dadurch gekennzeichnet, daß die Wellengeneriervorrichtung mit variabler Frequenz (441, 502) einen spannungsgesteuerten Oszillator (502) enthält, der durch die DC-Komponente gesteuert ist.

7. Verstärker für zusammengesetzte Wellen mit konstanter Amplitude nach einem der vorhergehenden Ansprüche, dadurch gekennzeichnet, daß die Verstärkungsvorrichtung mit variabler Verstärkung (448) zum Verstärken der ersten oder zweiten Welle konstanter Amplitude mit einer Verstärkung gemäß dem Steuersignal, wie es durch die Steuervorrichtung erzeugt wird, vorgesehen ist.

8. Verstärker für zusammengesetzte Wellen mit konstanter Amplitude nach Anspruch 7, dadurch gekennzeichnet, daß ein zweites Filter (523) vorgesehen ist, zum Extrahieren einer zweiten DC-Komponente von der Verzerrungskomponente, um diese der Verstärkervorrichtung mit variabler Verstärkung zuzuführen.

9. Verstärker für zusammengesetzte Wellen mit konstanter Amplitude nach Anspruch 8, dadurch gekennzeichnet, daß die Verstärkervorrichtung mit variabler Verstärkung einen Steuerverstärker mit automatischer Verstärkung (521) enthält, gesteuert anhand der zweiten DC-Komponente.

## Revendications

1. Amplificateur du type à combinaison d'ondes d'amplitudes constantes, comportant:
un moyen (441, 502) de production d'une onde à fréquence variable, pour produire une première onde (A) d'amplitude constante dont la fréquence peut être commandée par un signal de commande;
un premier moyen (442, 501) de combinaison d'ondes, couplé audit moyen de production d'une onde à fréquence variable, pour produire une deuxième onde (B) d'amplitude constante en combinant une onde d'entrée (X) et ladite première onde (A) d'amplitude constante;
un premier amplificateur (443, 503) amplifiant ladite première onde d'amplitude constante et délivrant une première sortie amplifiée (kA);
un deuxième amplificateur (444, 504) amplifiant ladite deuxième onde d'amplitude constante et délivrant une deuxième sortie amplifiée (kB);
un deuxième moyen (445, 507) de combinaison d'ondes couplé audit premier et audit deuxième amplificateurs pour combiner ladite première et ladite deuxième sorties amplifiées et pour produire une onde de sortie (kX); et
un moyen de commande (447, 522) pour produire ledit signal de commande à partir de ladite onde d'entrée (X) et de ladite onde de sortie (kX) en créant une composante de distorsion (Δ, Δθ) contenue dans ladite onde de sortie (kX), et pour ajuster le moyen (441, 502) de production d'onde à fréquence variable de telle sorte que ladite composante de distorsion soit réduite.

2. Amplificateur du type à combinaison d'ondes d'amplitudes constantes selon la revendication 1, dans lequel un moyen d'atténuation (513) est prévu pour atténuer d'un niveau d'atténuation (1/k) prédéterminé ladite onde de sortie et pour délivrer une onde de sortie atténuée audit moyen de commande.

3. Amplificateur du type à combinaison d'ondes d'amplitudes constantes selon la revendication 2, dans lequel ledit moyen de commande comporte:
un premier amplificateur-limiteur (514) qui amplifie ladite onde de sortie atténuée et qui délivre une onde de sortie atténuée amplifiée;
un deuxième amplificateur-limiteur (515) qui amplifie ladite onde d'entrée et qui délivre une onde d'entrée amplifiée; et
un moyen de multiplication (516) couplé audit premier et audit deuxième amplificateurs-limiteurs, pour multiplier ladite onde d'entrée amplifiée par ladite onde de sortie atténuée amplifiée et pour produire un signal de différence indicatif de ladite composante de distorsion contenue dans ladite onde de sortie.

4. Amplificateur du type à combinaison d'ondes d'amplitudes constantes selon la revendication 2, dans lequel ledit moyen de commande comporte en outre:
un premier circuit de mise au carré (517) qui met au carré ladite onde de sortie atténuée et qui délivre un premier signal au carré;
un deuxième circuit (518) de mise au carré qui met au carré ladite onde d'entrée et qui délivre un deuxième signal au carré;
un soustracteur (519) couplé audit premier et audit deuxième circuits de mise au carré, pour délivrer un signal de différence indicatif d'une différence entre ledit premier et ledit deuxième signal au carré et indicatif de ladite composante de distorsion contenue dans ladite onde de sortie.

5. Amplificateur du type à combinaison d'ondes d'amplitudes constantes selon l'une quelconque des revendications précédentes, dans lequel un premier filtre (506) est prévu entre ledit moyen de commande et ledit moyen de production d'une onde à fréquence variable, lequel filtre extrait une première composante en courant continu de ladite composante de distorsion, pour la délivrer audit moyen de production d'une onde à fréquence variable.

6. Amplificateur du type à combinaison d'ondes d'amplitudes constantes selon la revendication 5, dans lequel ledit moyen (441, 502) de production d'une onde à fréquence variable comporte un oscillateur (502) commandé en tension, commandé par ladite composante en courant continu.

7. Amplificateur du type à combinaison d'ondes d'amplitudes constantes selon l'une quelconque des revendications précédentes, dans lequel un moyen (448) amplificateur à gain variable est prévu pour amplifier l'une parmi ladite première et ladite deuxième ondes d'amplitudes constantes avec un gain correspondant audit signal de commande produit par ledit moyen de commande.

8. Amplificateur du type à combinaison d'ondes d'amplitudes constantes selon la revendication 7, dans lequel un deuxième filtre (523) est prévu pour extraire une deuxième composante en courant continu de ladite composante de distorsion, pour la délivrer audit moyen amplificateur à gain variable.

9. Amplificateur du type à combinaison d'ondes d'amplitudes constantes selon la revendication 8, dans lequel ledit moyen amplificateur à gain variable comporte un amplificateur (521) à commande automatique du gain commandé par ladite deuxième composante en courant continu.
